# EUROPÄISCHE PATENTSCHRIFT

(11) **EP 3 859 878 B1**
(45) Veröffentlichungstag und Bekanntmachung des Hinweises auf die Patenterteilung: **06.08.2025**
(21) Anmeldenummer: 21153586.9
(22) Anmeldetag: 26.01.2021
(51) Int. Cl.: H01Q 1/22, H01Q 15/00

(54) **ANTENNENMODUL**
ANTENNA MODULE
MODULE D'ANTENNE

(30) Priorität: 28.01.2020 DE 102020200974
(43) Veröffentlichungstag der Anmeldung: 04.08.2021
(73) Patentinhaber: Fraunhofer-Gesellschaft zur Förderung der angewandten Forschung e.V., 80686 München (DE)
(72) Erfinder: Landesberger, Christof, 80686 München (DE); Ramm, Peter, 80686 München (DE); Palavesam, Nagarajan, 80686 München (DE); Weber, Josef, 80686 München (DE)
(74) Vertreter: Pfitzner, Hannes

(56) Entgegenhaltungen:
- EP-A1- 2 469 592
- US-A1- 2011 032 685
- US-B1- 10 325 850
- STEFAN BEER ET AL: "Integrated 122-GHz Antenna on a Flexible Polyimide Substrate With Flip Chip Interconnect", IEEE TRANSACTIONS ON ANTENNAS AND PROPAGATION, IEEE SERVICE CENTER, PISCATAWAY, NJ, US, vol. 61, no. 4, 1 April 2013 (2013-04-01), pages 1564 - 1572, XP011499219, ISSN: 0018-926X, DOI: 10.1109/TAP.2012.2232260

## Beschreibung

Ausführungsbeispiele der vorliegenden Erfindung beziehen sich auf ein Antennenmodul sowie auf ein entsprechendes Herstellungsverfahren. Bevorzugte Ausführungsbeispiele beziehen sich auf ein 3D Glas-Wafer RF-Package. Weitere bevorzugte Ausführungsbeispiele betreffen ein Verfahren zur Herstellung eines Packages für einen Hochfrequenzchip (RF-Chip, Radio Frequency Chip), der mit einer Antenne zur Abstrahlung und/oder Empfangen von Radiowellen oder Mikrowellen ausgestaltet ist.

Bei hohen Frequenzen, insbesondere im RADAR Bereich, über 60 GHz bis hin zu THz (mm-Wellen), gibt es eine Reihe von elektrotechnischen Anforderungen, die erfüllt sein müssen, um ein gut performantes Chip-Antennen-System zu realisieren, das möglichst wenig Verlustleistung (= Abwärme) generiert; dazu gehören:
- Vermeidung von Induktivitäten in den Leiterbahnen zwischen Antenne und RF-Chip; d. h. z. B. Vermeidung von den üblicherweise genutzten Gold-Draht-Bonds auf den Chip-Kontaktflächen, da diese Bonddrähte einen halben "loop" einer Leiterbahn-Windung darstellen und somit eine Induktivität, die Verluste generiert.
- Möglichst kurze Leiterbahnwege, also z. B. ein integriertes Package von Chip und Antenne.
- Präzise geometrische Definition (möglichst im Mikrometerbereich) von allen Materialien, Schichtdicken, Leiterbahnen und Isolatoren im Package. Nur dann stimmt die Fertigungstechnologie sehr gut mit zuvor durchgeführten RF-Simulationen überein. Auch sollte sich das Package bei Wärmeeinwirkung nicht verformen, da es sonst wieder zu Abweichungen von der gewünschten RF Charakteristik kommt.

Damit RF-Signale möglichst verlustfrei übertragen werden können, soll das umgebende, elektrisch isolierende Dielektrikum eine möglichst niedrige Dielektrizitätskonstante (Permittivität) aufweisen, um Streukapazitäten zu minimieren.

Im Stand der Technik sind schon einige Ansätze zur Vermeidung von Drahtbondkontakten bekannt: Flip-Chip Bonden auf einem Substrat (PCB oder Silizium-Wafer) und auch Einbett-Technologien, bei denen ein RF-Chip in einer Kavität eines Si-Wafers versenkt wird und anschließend eine quasi planare Ankontaktierung zu dem Chip auf der Vorderseite des Wafers realisiert wird.

In diesem Zusammenhang sei auf folgende Publikationen verwiesen:
Die EP 3 346 549 A1 beschreibt ein Modul mit integrierter Antenne. Ferner ist auf die Veröffentlichungen mit dem Titel "Broadband Interconnect Design for Silicon-Based System-in-Package Applications up to 170 GHZ" und dem Titel " High-Efficiency 60 GHz Antenna Fabricated Using Low-Cost Silicon Micromachining Techniques" verwiesen.

Die Offenbarung der US 10325850 B1 zeigt eine Antennenanordnung mit einem Substrat und einem Deckel. Analog dazu offenbart die Veröffentlichung mit dem Titel: "Integrated 122-GHz Antenna on a Flexible Polyimide Substrate with Flip Chip Interconnect" die Verwendung eines Antennensubstrats im Zusammenhang mit einem LTCC-Package. Des Weiteren formt die EP 2469592 weiteren Stand der Technik.

Ebenso ist bekannt, dass die RF-Antenne in Form einer Luft-gefüllten Kavität ausgeführt sein kann und eine RF-Signalleitung zur Mitte über die Kavität geführt wird.

Nachteilig bei diesen bekannten Konzepten ist, dass der Leiterbahnsteg über der Antennenkavität keine mechanische Fixierung aufweist, wenn die Kavität mit Luft gefüllt sein soll. Wenn der Leiterbahnsteg nur über eine Beschichtung (z. B. Polymer oder Folie) fixiert wird, führt jede mechanische Auslenkung des Stegs zu einer Veränderung der Abstrahlcharakteristik. Weiterer Nachteil im Stand der Technik ist, dass die Oberseite des Wafers, in dem die RF-Chips eingebettet sind, offen gegenüber der Umwelt sind; d. h. es stellt noch kein sicheres oder hermetisches Package dar.

Deshalb besteht der Bedarf nach einem verbesserten Ansatz, wobei insbesondere oben beschriebene Nachteile bei der Integration vermieden werden.

Aufgabe der vorliegenden Erfindung ist es, ein integriertes Konzept von RF-Komponenten, insbesondere RF-Antenne und RF-Chip zu schaffen, das ein verbesserter Kompromiss aus mechanischer Stabilität, Abstrahlcharakteristik und Herstellbarkeit schafft.

Ausführungsbeispiele der vorliegenden Erfindung schaffen ein Antennenmodul mit einem ersten (z.B. isolierenden) Substrat, einem zweiten Substrat, das zumindest eine Kavität an einer ersten Hauptoberfläche des zweiten Substrats aufweist. Hierbei weist das erste Substrat zumindest ein RF-Element, einen RF-Chip und/oder eine RF-Leiterbahn auf. Das RF-Antennenelement, der RF-Chip und/oder die RF-Leiterbahn ist auf oder in der ersten Hauptoberfläche des ersten Substrats angeordnet/gebildet. Das erste Substrat ist z.B. mit seiner ersten Hauptoberfläche mit der ersten Hauptoberfläche des zweiten Substrats derart verbunden, dass das RF-Element und/oder der RF-Chip und/oder die RF-Leiterbahn mit zumindest einer Kavität fluchtend oder überlappend ausgerichtet ist bzw. so dass RF-Antennenelement und/oder der RF-Chip und/oder die RF-Leiterbahn aus der ersten Hauptoberfläche hinausragt und/oder in die zumindest eine Kavität hineinragt. Weitere Merkmale sind durch den unabhängigen Patentanspruch 1 definiert.

Entsprechend bevorzugten Ausführungsbeispielen ist das RF-Antennenelement und/oder der RF-Chip und/oder die RF-Leiterbahn derart ausgebildet, dass diese aus der ersten Hauptoberfläche des ersten Substrats herausragt und/oder in die zumindest eine Kavität hineinragt.

Ausführungsbeispielen der vorliegenden Erfindung liegt die Erkenntnis zugrunde, dass die RF-Chip(-Montage) und/oder die RF-Leiterbahnen auf einem (hochohmiges) Substrat (ohne Einschränkung der Allgemeinheit z. B. Glas-Wafer oder Keramik-Wafer oder Polymer-Wafer) ausgeführt werden kann. Durch das Aufsetzen eines Silizium-Wafers oder allgemein eines weiteren Substrats in justierter Weise auf dem mit den RF-Chips bzw. RF-Leiterbahnen bestückten Substrat kann ein RF-Package geschaffen werden. Entsprechend Ausführungsbeispielen wird das Aufsetzen in justierter Weise z. B. durch Kleben oder Bonden geschaffen. Wie bereits oben erwähnt, weist das weitere Substrat (Silizium-Wafer) eine oder mehrere Kavitäten auf. Entsprechend Ausführungsbeispielen können in diese Kavitäten die RF-Elemente, wie z. B. der RF-Chip (der auf der Oberfläche des Substrats aufgebracht ist) vertikal "versenkt" werden/sein. Des Weiteren kann durch Interaktion des RF-Antennenelements mit einer Kavität eine sogenannte Kavitätenantenne geformt werden. Dieses RF-Package erfüllt vorteilhafterweise Anforderungen hinsichtlich Stabilität, Hermitizität und auch hinsichtlich Abstrahleigenschaften, was beispielsweise aus der Möglichkeit resultiert, ein oder mehrere Substrate zu perforieren.

Entsprechend Ausführungsbeispielen kann das zweite Substrat eine Leiterbahn, eine auf der ersten Hauptoberfläche angeordnete Leiterbahn oder eine Leiterbahn in der Kavität bzw. auf dem Boden der Kavität aufweisen. Entsprechend Ausführungsbeispielen kann entweder das Substrat RF-Leiterbahnen oder allgemein Leiterbahnen aufweisen. Die neue Idee basiert somit allgemein auf einem 3D-Substratstapel bestehend aus einem Substrat (z. B. Glas) und einem Si-Substrat, wobei es elektrische Verbindungswege auf und zwischen den beiden gestapelten Substraten gibt. Die vertikalen Verbindungswege können ohne Einschränkung der Allgemeinheit mittels Substratdurchkontaktierungen realisiert werden (z.B. im Falle eines Si-Substrats mittel Through-Si Vias (TSV). Insofern kann entspre chend weiteren Ausführungsbeispielen auch das weitere Substrat sowohl der ersten Hauptoberfläche bzw. auf Seiten der ersten Hauptoberfläche oder auf Seiten der gegenüberliegenden zweiten Hauptoberflächen Leiterbahnen aufweisen. Die Durchkontaktierung kann z.B. beispielsweise mittels Vias, z. B. TSV (Through Silicon Via) erfolgen.

Bei obigen Ausführungsbeispielen wurde davon ausgegangen, dass die RF-Elemente (RF-Antennenelement, RF-Chip und/oder RF-Leiterbahn) auf oder in das Substrat aufgebracht ist. Hierbei kann entsprechend Ausführungsbeispielen das jeweilige oder die jeweiligen RF-Elemente aus der Hauptoberfläche hinausragen und/oder in die zumindest eine Kavität hineinragen. Entsprechend weiteren Ausführungsbeispielen wäre es auch denkbar, dass mehrere Kavitäten vorgesehen sind, die unterschiedlichen RF-Elementen zugeordnet sind.

Bezüglich den Kavitäten sei angemerkt, dass diese allgemein mit Luft, Gas und einem Vakuum gefüllt sein können. Gemäß der Erfindung weist die Kavität bzw. allgemein das Antennenmodul ein sogenanntes Metamaterial auf, angeordnet auf dem Boden der Kavität. Das Metamaterial ist dem RF-Antennenelement zugeordnet, das heißt also in der Kavität angeordnet, die zum RF-Antennenelement gehört. Das Metamaterial verbessert vorteilhafterweise die Abstrahlcharakteristik des Antennenelements. Entsprechend weiteren Ausführungsbeispielen kann auch ein thermisches Element vorgesehen sein. Dieses thermische Element ist z. B. in einer Kavität oder auf dem Boden der Kavität vorgesehen. Das thermische Element kann dem RF-Chip zugeordnet sein und verbessert so die Temperaturabführung.

Bezüglich den Substraten sei angemerkt, dass das zweite Substrat beispielsweise durch einen Substratstapel geformt sein kann. Hier ist also beispielsweise ein Substrat, wie z. B. ein Silizium-Substrat mit Öffnungen, vorgesehen, das durch ein sogenanntes Deckelelement bzw. Deckelsubstrat verschlossen wird. Entsprechend Ausführungsbeispielen kann das Deckelsubstrat ein Substrat sein. Allgemein kann der Substratstapel ein isolierendes Substrat aufweisen. Im Allgemein sei bezüglich des zweiten Substrat angemerkt, dass es sich bei diesem vorzugsweise um ein Halbleitersubstrat, wie z. B. ein Silizium-Substrat handelt. Umgekehrt handelt es sich bei dem Substrat beispielsweise um ein Substrat bestehend aus einem Glasmaterial, einem Keramikmaterial oder einem Polymermaterial. Diese Materialarten haben Vorteile bezüglich den RF-Antenneneigenschaften. Entsprechend Ausführungsbeispielen kann dieses Substrat auch ein gedünntes Substrat sein. Hierbei wird beispielsweise das Substrat nach dem Verkleben mit dem zweiten Substrat gedünnt.

Das verbessert vorteilhafterweise die Eigenschaften hinsichtlich Integrierbarkeit des Antennenmoduls.

Ein weiteres Ausführungsbeispiel schafft ein Herstellungsverfahren. Das Verfahren umfasst die folgenden Schritte:
- Bereitstellen eines ersten (hochohmigen oder isolierenden) Substrats;
- Bereitstellen eines zweiten Substrats, wobei das zweite Substrat zumindest eine Kavität an einer ersten Hauptoberfläche aufweist; wobei das erste Substrat zumindest ein RF-Antennenelement und/oder einen RF-Chip und/oder eine RF-Leiterbahn aufweist, wobei das Antennenelement und/oder der RF-Chip und/oder die RF-Leiterbahn auf einer ersten Hauptoberfläche des ersten Substrats angeordnet ist; und
- Verbinden des ersten Substrats mit seiner ersten Hauptoberfläche mit der ersten Hauptoberfläche des zweiten Substrats, so dass RF-Antennenelement und/oder der RF-Chip und/oder die RF-Leiterbahn aus der ersten Hauptoberfläche hinausragt und/oder in die zumindest eine Kavität hineinragt..

Entsprechend einem weiteren Ausführungsbeispiel kann das Verbinden mittels Flip-Chip-Technologien bzw. "Face-to-Face Waferbonding" erfolgen.

Entsprechend einem Ausführungsbeispiel kann vor dem Bereitstellen das Strukturieren, wie z. B. Ätzen, Trockenätzen des zweiten Substrats erfolgen, um die zumindest eine Kavität in die erste Hauptoberfläche einzubringen. Hierbei werden konventionelle Halbleiterherstellungsverfahren verwendet. Der Schritt kann entsprechend weiteren Ausführungsbeispielen auch das Vorsehen bzw. Einbringen von elektrischen Leiterbahnen oder anderen Elementen, wie z. B. dem thermischen Element oder dem Metamaterial, aufweisen. Entsprechend einem Ausführungsbeispiel kann vor dem Bereitstellen des ersten Substrats und/oder des zweiten Substrats ein oder mehrere Halbleiterherstellungsschritte durchgeführt werden, um ein RF-Element, eine RF-Leiterbahn, ein Metamaterial, ein thermisches Material, eine RF-Leiterbahn, einen RF-Chip und/oder ein RF-Antennenelement auf das erste und/oder das zweite Substrat aufzubringen.

Entsprechend weiteren Ausführungsbeispielen wäre es denkbar, dass ein Dünnen des ersten Substrats nach dem Verbinden erfolgt. Nachdem Verbinden weist das Substrat genügend Stabilität auf, so dass das Material gedünnt werden kann. Ferner kann auch ein Dünnen des zweiten Substrats erfolgen, z.B. um die Kavitäten von der Rückseite zu öffnen. Das Verschließen kann dann durch einen weiteres Substrat erfolgen. Hierbei wird dann ein Schichtstapel anstelle des zweiten Substrats geformt.

Die Weiterbildung ist in den Unteransprüchen definiert. Ausführungsbeispiele der vorliegenden Erfindung werden anhand der beiliegenden Zeichnungen näher erläutert. Es zeigen:
- Fig. 1: eine schematische Darstellung eines Antennenmoduls gemäß einem Basisausführungsbeispiel;
- Fig. 2a: eine schematische Darstellung der Bauelementkomponenten im Querschnitt für eine Montage gemäß einem ersten erweiterten Ausführungsbeispiel;
- Fig. 2b: eine schematische Darstellung der Bauelementkomponenten im Querschnitt in montierter Form gemäß dem Ausführungsbeispiel aus Fig. 2a;
- Fig. 3a und 3b: schematische Darstellungen von Bauelementkomponenten im Querschnitt (Vormontage und Nachmontage) gemäß einem zweiten erweiterten Ausführungsbeispiel; und
- Fig. 4a-c: schematische Darstellungen von Bauelementkomponenten im Querschnitt (Vormontage, teilmontiert und montiert) gemäß einem dritten erweiterten Ausführungsbeispiel.

Nachfolgend werden Ausführungsbeispiele der vorliegenden Erfindung unter Bezugnahme auf die Figuren erläutert. Hierbei werden gleiche Bezugszeichen für gleiche Elemente und Strukturen verwendet, so dass die Beschreibung derer aufeinander anwendbar bzw. austauschbar ist.

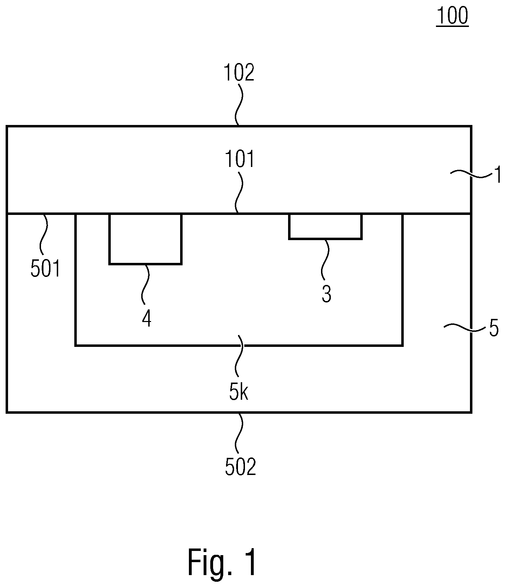

Fig. 1 zeigt ein Antennenmodul 100 mit einem ersten Substrat 1 sowie einem zweiten Substrat 5. Das erste Substrat ist beispielsweise ein hochohmiges oder elektrisch isolierendes Substrat, das ein Glas, eine Keramik oder eine Glaskeramik aufweisen kann. Beim zweiten Substrat 5 kann es sich beispielsweise um ein Halbleitersubstrat handeln. Die Substrate sind, z. B. mittels Flip-Chip oder Face-to-Face Waferbonding miteinander über jeweils erste Hauptoberflächen 101 bzw. 501 verbunden.. Die gegenüberliegenden zweiten Hauptoberflächen 1o2 und 5o2 sind die nach außen gerichteten Hauptoberflächen des Moduls 100.

Das erste Substrat 1 weist auf der ersten Hauptoberfläche 1o1 zumindest ein RF-Element auf. Hier sind exemplarisch zwei RF-Elemente, nämlich ein RF-Chip 4 und eine RF-Antenne 3 gezeigt. Diese können entsprechend Ausführungsbeispielen in der Hauptoberfläche 1o1 oder auch, wie hier dargestellt, auf der Hauptoberfläche 1o1 geformt sein.

Das Substrat 5 weist eine Kavität 5k auf, die auf Seiten der ersten Hauptoberfläche 5o1 vorgesehen ist. Die Kavität 5k ermöglicht, dass trotz der ein oder mehreren RF-Elemente 3 und 4 die Substrate 1 und 5 über deren Hauptoberflächen 1o1 und 5o1 verbunden werden können. Hierzu ragen die Elemente 3 und 4 in die Kavität 5k hinein. Aus lateraler Sicht sind hierzu die Elemente 3 und 4 der zumindest einen Kavität 5k zugeordnet, so dass nach Verbindung der Substrate die Elemente 3 und 5 lateral zu der Kavität ausgerichtet sind. Wie dargestellt, ragen die Elemente 3 und 5 aus der Hauptoberfläche 1o1 heraus und in die Kavität 5k hinein. Hierzu ist die Kavität beispielsweise in Bezug auf die Tiefe an die Höhe der Elemente 3 und 4 angepasst.

Wie in Fig. 1 dargestellt, wird das Antennenmodul 100 durch ein Package umfassend einen Stapel von Substraten, z. B. dem isolierenden Substrat 1 und dem weiteren Substrat 5 (z. B. Silizium-Substrat) geformt sein. Die Verwendung des isolierenden Substrat, z. B. Glas, ist deshalb vorteilhaft, weil dieses durchlässig für Radiowellen ist. Dazu kommt, dass Glas-Wafer 1 in Halbleiter-Fertigungs-Linien mit den bekannten Verfahren zur lithografischen Strukturierung von hoch präzise definierten Leiterbahnen 3 bearbeitet werden können. Eine zuvor in einer elektromagnetischen Simulation optimierte Package-Struktur 100 kann somit hoch präzise in ein reales Package überführt und hergestellt werden.

Zum Herstellungsverfahren sei angemerkt, dass die zwei Substrate 1 und 5 in einem Basisschritt bereitgestellt werden und dann in einem weiteren Basisschritt miteinander verbunden werden. Hierdurch bietet sich eine Flip-Chip-Montage oder Face-to-Face Waferbonding an, wobei unterschiedliche Verbindungstechniken, wie z. B. Kleben oder Bonden in Frage kommen. Deshalb kann entsprechend Ausführungsbeispielen nur auch zwischen den zwei Substraten 1 und 5 eine Verbindungsschicht, wie z. B. Klebeschicht oder isolierende Klebeschicht oder Isolationsschicht vorgesehen sein. Diese Schicht isoliert zumindest an den Berührpunkten bzw. Verbindungspunkten die Oberflächen 5o1 und 1o1 voneinander. Wie oben bereits angedeutet, können entsprechend Ausführungsbeispielen zur Herstellung des Glassubstrats bzw. allgemeines isolierendes Substrats 1 Standard-Halbleiterherstellungsverfahren angewendet werden. Bei diesem Verfahren entsteht also die Chip-Antennen-Verbindung auf einem isolierenden Substrat. Analog kann die Kavität bzw. die Öffnung des zweiten Substrats 5 auch mittels Standardherstellungsverfahren, z. B. Trockenätzen, eingebracht werden.

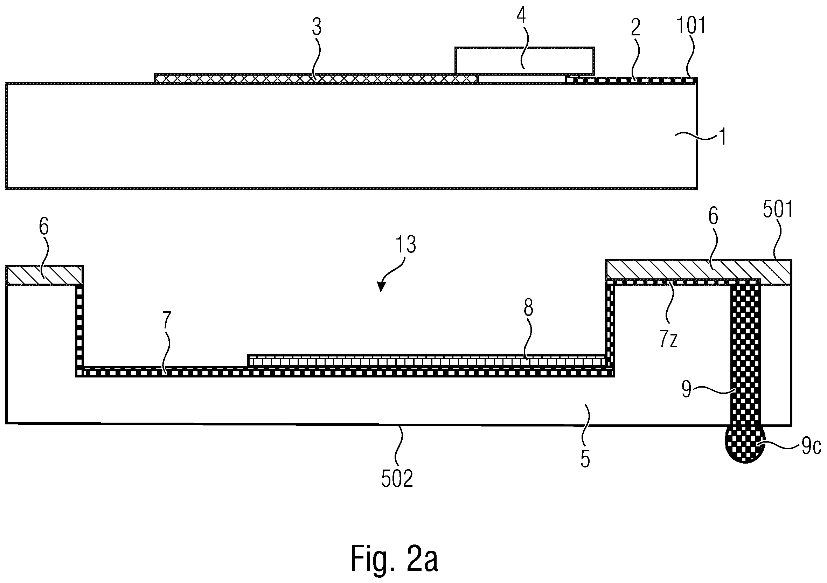

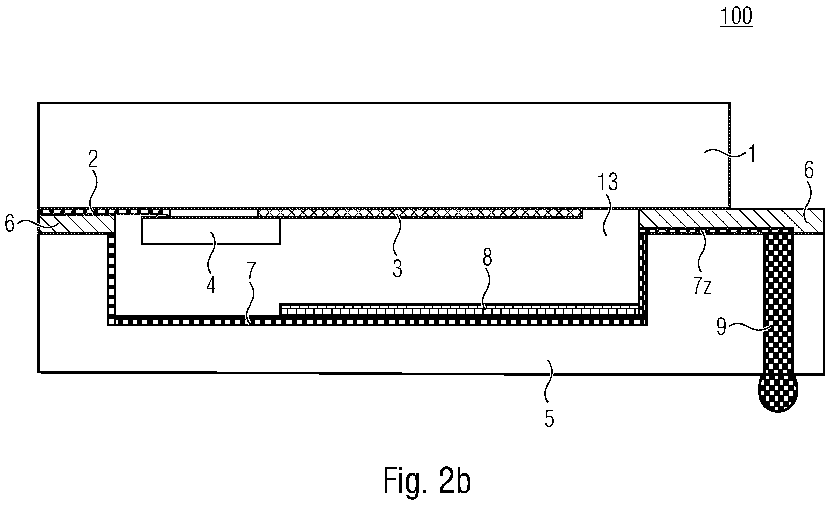

Nachfolgend wird bezugnehmend auf Fig. 2a und 2b ein weiteres Ausführungsbeispiel erläutert.

Fig. 2a zeigt die zwei noch voneinander separierten Substrate 1 und 5. Die entsprechenden Hauptoberflächen, die verbunden werden sollen, sind mit dem Bezugszeichen 5o1 und 1o1 markiert.

Auf das Substrat 1 ist neben dem RF-Chip 4 die RF-Antenne 3 sowie eine Zuleitung 2 auf die Hauptoberfläche 1o1 aufgebracht.

Das Substrat 5 weist eine Kavität 13 auf. In diesem Ausführungsbeispiel ist die Kavität 13 mit einer Kavitätenmetallisierung 7 versehen. An den vertikalen Wänden können sich Zuleitungen befinden. Die Zuleitung ist mit dem Bezugszeichen 7z markiert und verbindet die Kavitätenmetallisierung 7 beispielsweise mit dem elektrisch leitenden Durchkontaktierungselement (Via 9). Dieses ragt durch das gesamte Substrat 5 von der ersten Hauptoberfläche 5o1 zu der zweiten Hauptoberfläche 5o2 hindurch. Auf der zweiten Hauptoberfläche 5o2 ist ein Anschlusselement, z. B. in Form einer Lotkugel 9l vorgesehen. Auf dem Boden der Kavität 19 ist, wie bereits gesagt, die Kavitätenmetallisierung 7 vorgesehen. Zusätzlich kann auf dem Boden bzw. auf der Kavitätenmetallisierung 7 auch noch eine Metamaterialschicht 8 angeordnet sein. Metamaterialien sind Materialien, deren elektrische und magnetische Eigenschaften (Permittivität εᵣ und Permeabilität µᵣ) variabel einstellbar sind. Dies gelingt zum Beispiel durch Mikro- und Nanostrukturierung von leitfähigen und nicht-leitfähigen bzw. magnetischen Beschichtungen. Bezüglich der Kavitätenmetallisierung 7 und auch dem Metamaterial 8 sei angemerkt, dass sich beide Elemente, z. B. über die gesamte Breite der Kavität 13 oder auch nur über einen Bereich der Kavität 13 erstrecken können. Hier ist eine Variante dargestellt, bei der sich die Kavitätenmetallisierung über die gesamte Breite und das Metamaterial über eine reduzierte Breite erstreckt. D.h. also, dass entsprechend Ausführungsbeispielen die Kavitätenmetallisierung 7 strukturiert sein kann. Beispielsweise ist der Boden strukturiert, um das Abstrahlverhalten zu beeinflussen.

Auf der ersten Hauptoberfläche 5o1 des Substrats 5 ist in dem hier in Fig. 2a dargestellten Bauzustand auch noch eine Isolationsschicht 6 bzw. ein isolierender Kleber vorgesehen. Über diese Isolationsschicht 6 bzw. den isolierenden Kleber 6 wird dann Verbindung zu der ersten Hauptoberfläche 1o1 hergestellt, wie bezugnehmend auf 2b ersichtlich wird.

Bei Fig. 2b ist die erste Hauptoberfläche 1o1 des Substrats 1 mit der ersten Hauptoberfläche 5o1 des Substrats 5 verbunden. Die Verbindung erfolgt, wie bereits angedeutet, über die Klebeschicht 6, die hier die gesamte Hauptoberfläche 5o1 bedeckt. An dieser Stelle sei angemerkt, dass das Substratmodul 1 kleiner sein kann als das Substratmodul 5, wobei vorzugsweise die Größe so gewählt ist, dass die Kavität 13 zumindest vollständig bedeckt wird bzw. verschlossen ist. Diese Kavität 13 kann beispielsweise mit einem Gas, wie z. B. Luft, gefüllt sein.

Wie zu erkennen ist, sind die RF-Elemente hier 3 und 4 lateral im Bereich der Kavität 13 angeordnet, während beispielsweise der RF-Steg die Zuleitung auch im Bereich neben der Kavität überlappen kann. In diesem Bereich kann dann eine elektrische Verbindung erfolgen. Dies ist nicht dargestellt, ragt aber beispielsweise durch das Isolationsmaterial 6 hindurch. An dieser Stelle sei auch angemerkt, dass das Isolationsmaterial 6 diesseits und jenseits der Kavität unterschiedlich dick vorgesehen sein kann, um einen entsprechenden Höhenausgleich an dieser Stelle zu schaffen. Vorteilhaft an dieser Anordnung ist, dass der Steg zur Einleitung des RF-Signals, z. B. die Verbindung zwischen 4 und 3 oder auch das Element 3 sich befindet und auch geometrisch definiert ist. In Ausführungsbeispielen ist das Metamaterial 8 lateral in dem Bereich der Antenne 3 vorgesehen. Deshalb ergibt sich ein Metamaterial 8 mit einer reduzierten Breite.

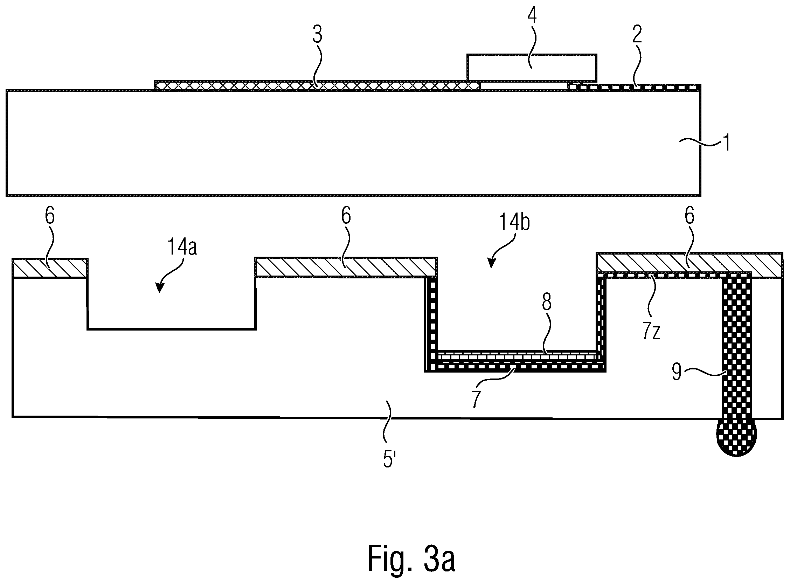

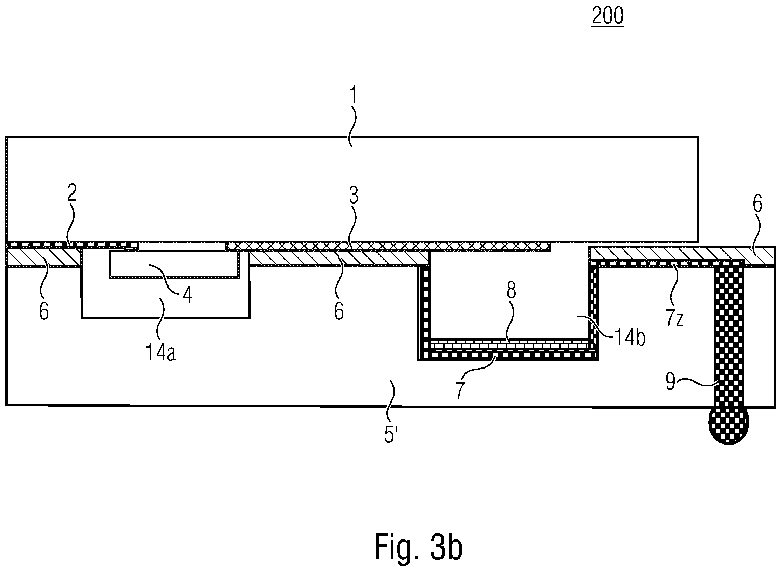

Nachfolgend wird bezugnehmend auf Fig. 3a und 3b ein weiteres Ausführungsbeispiel erläutert, bei welchem die Elemente 3 und 4 zu unterschiedlichen Kavitäten 13 und 14 vorgesehen sind.

Fig. 3a zeigt wiederum den Zustand, bei welchem die Substrate 1 und 5' noch voneinander separiert sind. In diesem Ausführungsbeispiel umfasst also das Substrat 5' zwei Kavitäten 14a und 14b. Die Kavität 14a ist für den Chip 4 vorgesehen, während die Kavität 14b für die RF-Antenne 3 vorgesehen ist. Deshalb umfasst die Kavität 14b auch optionalerweise das Metamaterial 8 auf dem Boden bzw., um genau zu sein, auf der Kavitätenmetallisierung 7. Die restlichen Elemente, wie z. B. die Zuleitung 7z oder das Via 9 oder die Klebeschicht 6 sind vergleichbar mit denen aus dem Ausführungsbeispiel aus Fig. 2a und 2b.

Wie hier dargestellt, können entsprechend Ausführungsbeispielen die Tiefen der Kavitäten 14a und 14b voneinander variieren. Hier ist die Kavität 14b, die mit dem RF-Antennenelement 3 die Kavitätenantenne formt, tiefer ausgebildet. Über die Tiefe werden beispielsweise auch RF-Eigenschaften der Kavitätenantenne eingestellt. Die Tiefe der Kavität 14a ist so gewählt, dass der in die Kavität 14a hineinragende Chip 4 ausreichend Platz hat oder zumindest eingebettet ist.

Die Tiefe der Antennenkavität 14b kann an die gewünschte Wellenlänge der abgestrahlten oder empfangenen Wellenlänge angepasst werden. In einigen Fällen kann beispielsweise die Tiefe ein Viertel der Ziel-Wellenlänge, also λ/4, betragen. Bei Verwendung von Metamaterialien können auch andere Werte für die Tiefe der Kavität sinnvoll sein. Es ist ein Vorteil, dass die erfindungsgemäße Ausführung eine Variabilität der Kavitätentiefe ermöglicht und somit die Performanz (unter anderem die Energieeffizienz) des Systems optimiert werden kann.

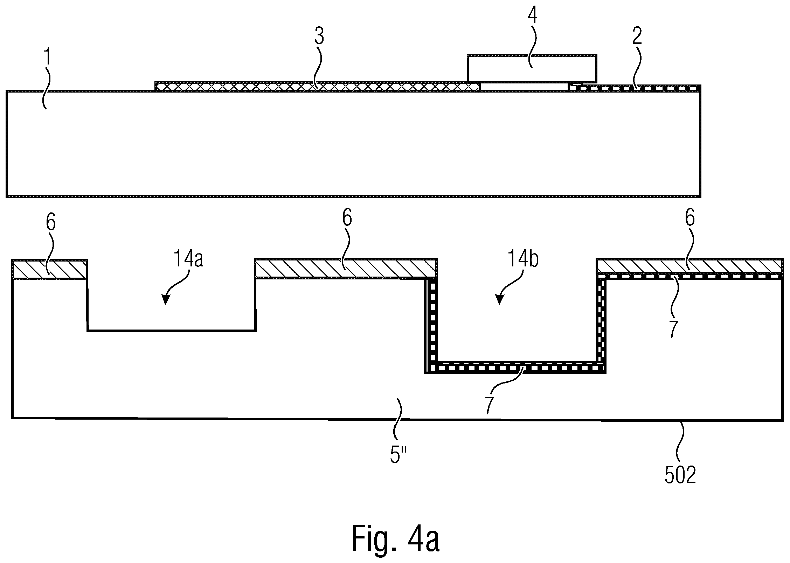

Bezugnehmend auf Fig. 4a wird nun ein Ausführungsbeispiel erläutert, bei welchem das zweite Substrat als Schichtstapel ausgeführt ist. In Fig. 4a sind die zwei Ausgangssubstrate gezeigt. Das Substrat 1 entspricht hinsichtlich seinen Elementen 2, 3, 4 dem Substrat 1 aus Fig. 2a oder 3a. Das Substrat 5" ist vergleichbar mit dem Substrat 5' aus Fig. 3a, wobei das Substrat 5" auf der Rückseite, das heißt also von der Hauptoberfläche 5o2 ausgedünnt wird. Hierbei sei angemerkt, dass vorzugsweise das Dünnen des Substrats 5" erfolgt, wenn das Substrat 5" mit dem Substrat 1 zu einem Waferstapel (Glas + Si) verbunden ist. Das Abdünnen erfolgt soweit, bis die Kavität 14a und 14b oder zumindest die Kavität der Antenne 14b offen ist.

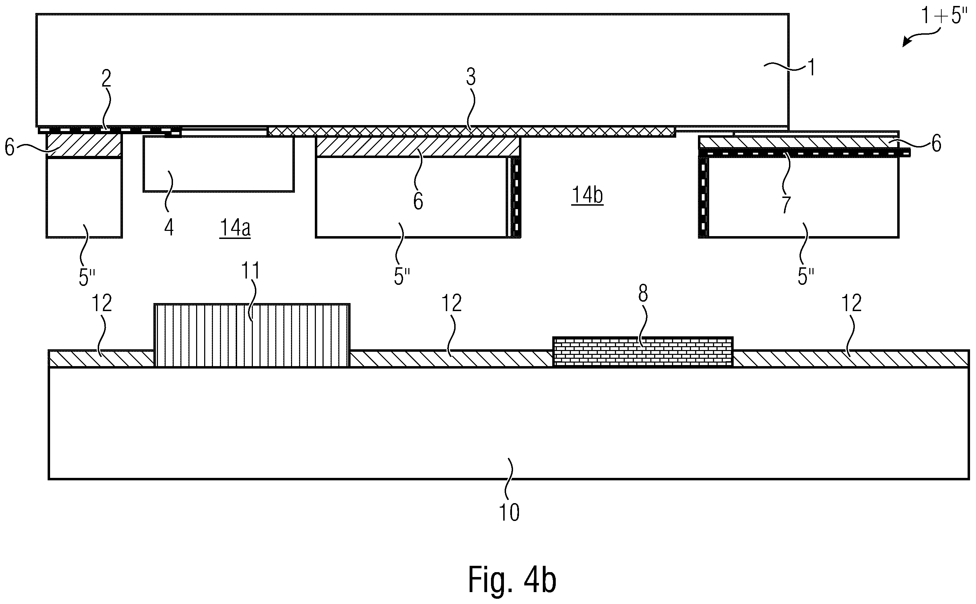

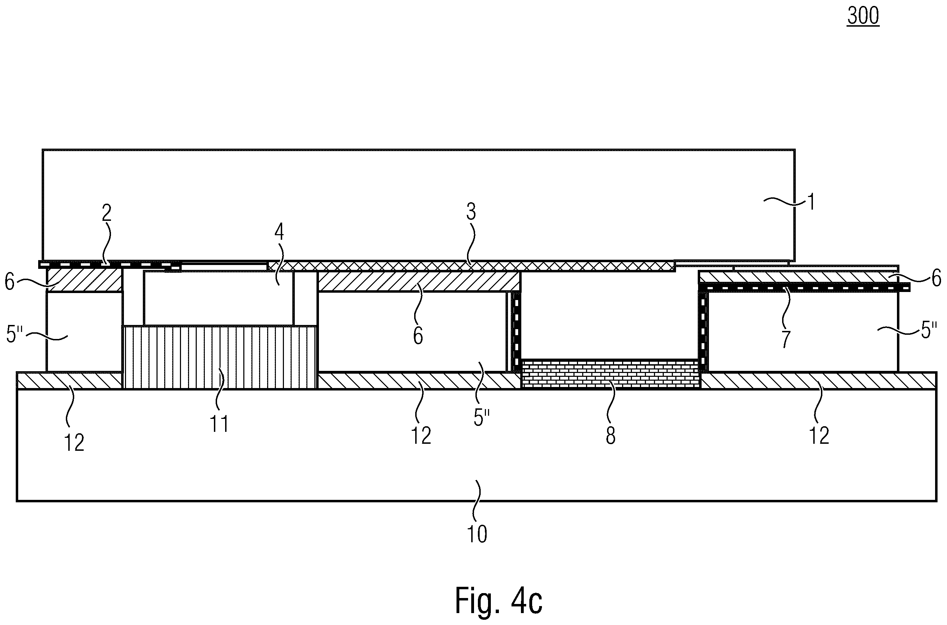

Der gedünnte Schichtstapel ist in Fig. 4b gezeigt und mit dem Bezugszeichen 1+5" versehen. Nach dem Dünnen sind dann die zwei Kavitäten 14a und 14b offen. Die offenen Kavitäten 14a und 14b können dann mit einem weiteren Substrat 10, wie z. B. einem weiteren Silizium-Substrat oder einem isolierenden Substrat verschlossen werden. In dem hier dargestellten Ausführungsbeispiel weist das weitere Substrat 10 eine Haftschicht 12 auf. Im Bereich der Kavitäten 14a und 14b können zusätzlich Elemente eingebracht werden. Ein Beispiel ist das oben bereits angesprochene Metamaterial 8 für die Kavität 14b zugeordnet zu der RF-Antenne 3. Ein weiteres Beispiel wäre ein thermisches Element 11 im Bereich der Kavität 14a zugeordnet zu dem Chip 4. Das kann beispielsweise eine thermische Kontaktfläche zu dem RFIC herstellen, um die Kühloberfläche zu verbessern. Insofern können auf diesem dritten Wafer 10 spezielle Strukturen für den Boden der Kavitäten 14a und 14b, z. B. für die Antenne realisiert sein. Neben dem Metamaterial können auch andere geometrisch spezifisch strukturierte Metallschichten vorgesehen sein, die eine weitere Optimierung der Kavitätenantenne 3+14b sorgen. Diese Verbindung zwischen dem Kühlelement 14 und dem Chip 4 oder auch das Ausformen der Kavitätenantenne mit dem Metamaterial 8 ist in Fig. 4c dargestellt. Das gesamte Antennenmodul ist mit dem Bezugszeichen 300 versehen.

Bezüglich der Ausführungsbeispiele aus Fig. 4b und 4c sei angemerkt, das diese folgende vorteilhafte Struktur offenbaren: ein als Schichtstapel ausgeführtes zweites Substrat 5', 5" mit zumindest zwei Einzelsubstraten; hier weist das erste der mindesten zwei Einzelsubstrate ein oder mehrere Kavitäten oder Öffnungen (von der einen Hauptoberfläche zu der anderen Hauptoberfläche) auf, während das zweite der mindesten zwei Einzelsubstrate zur Verkapselung der ein oder mehreren Öffnungen dient, um die ein oder mehreren Kavitäten zu formen. Insofern entsteht durch die Kombination von dem ersten Substrat und dem als Schichtstapel ausgeführten zweiten Substrat ein 3-Lagen-Waferstapel. Der unterste Wafer 10 in den Figuren 4b und 4c bietet die Möglichkeit, die Strukturierung des Antennenbodens (z. B. Metallmaterial) in bestmöglicher Qualität / optimaler Materialität eines Halbleiter-Wafertechnologie-Prozesses auszuführen. Der zweite Wafer ist ebenfalls hinsichtlich Leitungs- und Isolierungs-Eigenschaften optimiert. Beispielsweise kann das Kavitätensubstrat isolieren; additiv oder alternativ kann das Deckelsubstrat eine Metallisierung zur Herstellung der Leiterbahnen / Reflektoren aufweisen. Durch die Halbleiterherstellungsverfahren sind sehr feine Mikrostrukturen einstellbar, um die HF-Eigenschaften zu optimieren.

Entsprechend obigen Ausführungsbeispielen erfolgt die Abstrahlung der mm-Wellen durch den Glas-Wafer 1 hindurch. Um hier die Absorptionsverluste zu minimieren, kann der Glas-Wafer 1 abgedünnt / zurückgeschliffen werden. Dies wiederum ist vor allem dann sinnvoll möglich, wenn der Glas-Wafer 1 beim Rückdünnen stabilisiert wird. Genau das leistet der gebondete Si-Wafer 5 im Waferstapel. Das gedünnte Glas-Substrat 1 ist ein perfekter Schutz gegen Umwelteinflüsse (Feuchtigkeit). Alle Kontakte werden über die TSV 9 zur Rückseite oder zur Seite herausgeführt.

Bezüglich obigen Ausführungsbeispielen sei darauf hingewiesen, dass der zweite Wafer 5, 5' bzw. 5' vorzugsweise aus Silizium besteht; bietet also alle bekannten Strukturierungstechniken der Standard-Halbleitertechnologie; für den vorliegenden Fall sehr wichtig: Herstellung von präzise definierten Kavitäten (im Trocken-Ätzverfahren) und TSV Kontakte durch den Wafer. Vorteilhaft ist auch die hohe Wärmeleitfähigkeit des Si-Wafers, der somit eine gute Wärmeabfuhr vom RF-Chip ermöglicht. Der Chip wird in Flip-Chip Technik auf die Leiterbahnen montiert; dies vermeidet Drahtbonds und unerwünschte Induktivitäten.

Ausführungsbeispiele der vorliegenden Erfindung lassen sich also wie folgt charakterisieren: Elektronisches Modul 100, 200, 300, wobei das elektronische Modul ein nichtleitendes Substrat 1 mit einem auf der ersten Substratoberfläche angebrachten elektronischen Bauelement 4 und einer auf der ersten Substratoberfläche angebrachten Antenne 3 aufweist, wobei das elektronische Modul ein halbleitendes Substrat 5 mit mindestens einer Kavität 13 in einer ersten Oberfläche aufweist, und wobei die erste Oberfläche des nichtleitenden Substrats 1 mit der ersten Oberfläche des halbleitenden Substrats 5 verbunden ist, so dass das elektronische Bauelement 4 und die Antenne 3 in die mindestens eine Kavität oder jeweils in separate Kavitäten hineinragen.

Das ganze Package (Chip + Antenne) entsteht auf "wafer level", also kostengünstig mit unterschiedlichen integrierten Funktionalitäten Processing und Aussenden/Empfangen von RF-Signalen. Für Frequenzen über 100 GHz wird es besonders vorteilhaft, da die Abmessungen der Antenne nur noch wenige Millimeter betragen, somit also viele Packages auf einem Wafer gleichzeitig entstehen.

Das Herstellungsverfahren lässt sich wie folgt beschreiben:
- Bereitstellen eines nichtleitenden Substrats 1 mit einem auf der ersten Substratoberfläche angebrachten elektronischen Bauelement 4 und einer auf der ersten Substratoberfläche angebrachten Antenne 3 bzw. einer Leiterbahnstruktur 3.
- Bereitstellen eines Substrats 5 (halbleitend oder isolierend) mit mindestens einer Kavität 13 in einer ersten Oberfläche
- Verbinden der ersten Oberfläche des nichtleitenden Substrats 1 mit der ersten Oberfläche des halbleitenden Substrats 5, so dass das elektronische Bauelement 4 und die Antenne 3 in die mindestens eine Kavität oder jeweils in separate Kavitäten hineinragen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

## Patentansprüche

1. Antennenmodul, umfassend folgende Merkmale:
ein erstes Substrat (1),
ein zweites Substrat (5, 5', 5"), wobei das zweite Substrat (5, 5', 5") zumindest eine Kavität (13, 14, 14a, 14b) an einer ersten Hauptoberfläche aufweist,
wobei das erste Substrat (1) zumindest ein RF-Antennenelement (3) aufweist, insbesondere einen RF-Chip (4) und/oder eine RF-Leiterbahn aufweist, wobei das RF-Antennenelement (3) oder der RF-Chip (4) oder die RF-Leiterbahn auf oder in einer ersten Hauptoberfläche des ersten Substrats (1) angeordnet ist,
wobei das erste Substrat (1) mit seiner ersten Hauptoberfläche mit der ersten Hauptoberfläche des zweiten Substrats (5, 5', 5") verbunden ist;
wobei das RF-Antennenelement (3) oder der RF-Chip (4) oder die RF-Leiterbahn aus der ersten Hauptoberfläche des ersten Substrats hinausragt und in die zumindest eine Kavität (13, 14, 14a, 14b) hineinragt,
wobei das erste Substrat (1) ein hochohmiges oder isolierendes Substrat ist, insbesondere ein Glasmaterial, oder ein Keramikmaterial oder ein Polymermaterial aufweist,
**dadurch gekennzeichnet, dass** die zumindest eine Kavität (13) eine elektrisch kontaktierte Kavitätenmetallisierung (7) mit einer reduzierten Breite aufweist, sodass sich die Kavitätenmetallisierung (7) nur über einen Bereich der zumindest einen Kavität (13) erstreckt;
wobei das Antennenmodul ein Metamaterial (8), das auf einem Boden der zumindest einen Kavität (13, 14, 14a, 14b) angeordnet ist und das dem RF-Antennenelement (3) zugeordnet ist, aufweist.

2. Antennenmodul gemäß Anspruch 1, wobei mehrere Kavitäten (13, 14, 14a, 14b) bei der ersten Hauptoberfläche des zweiten Substrats (5, 5', 5") vorgesehen sind, die unterschiedlichen RF-Elementen zugeordnet sind.

3. Antennenmodul gemäß einem der vorherigen Ansprüche, wobei das zweite Substrat (5, 5', 5") durch einen Substratstapel geformt ist, oder
wobei das zweite Substrat (5, 5', 5") durch einen Substratstapel geformt ist und der Substratstapel ein Substrat (1) oder ein Substrat (1), das als Deckelelement für die zumindest eine Kavität (13, 14, 14a, 14b) fungiert, umfasst.

4. Antennenmodul gemäß einem der vorherigen Ansprüche, wobei das zweite Substrat (5, 5', 5") eine Leiterbahn, insbesondere eine Leiterbahn auf der ersten Hauptoberfläche, eine Leiterbahn in der zumindest einen Kavität (13, 14, 14a, 14b) oder eine Leiterbahn auf einem Boden der zumindest einen Kavität (13, 14, 14a, 14b) aufweist.

5. Antennenmodul gemäß einem der vorherigen Ansprüche, wobei die Verbindung zwischen dem ersten Substrat (1) und dem zweiten Substrat (5, 5', 5") durch eine Klebeschicht, eine isolierende Klebeschicht oder eine Isolationsschicht gebildet ist.

6. Antennenmodul gemäß einem der vorherigen Ansprüche, wobei das zweite Substrat (5, 5', 5") ein oder mehrere Vias (9), insbesondere ein oder mehrere Vias (9), die durch das zweite Substrat (5, 5', 5") hindurchragen, aufweist.

7. Antennenmodul gemäß einem der vorherigen Ansprüche, wobei das zweite Substrat (5, 5', 5") ein Halbleitermaterial aufweist.

8. Antennenmodul gemäß einem der vorherigen Ansprüche, wobei die Kavitätenmetallisierung (7) über einen partiellen Bereich der Kavität (13) erstreckt oder wobei die Kavitätenmetallisierung (7) Strukturiert ist.

9. Antennenmodul gemäß einem der vorherigen Ansprüche, wobei das erste Substrat (1) und/oder das zweiten Substrat (5, 5', 5") durch ein gedünntes Substrat gebildet ist.

10. Antennenmodul gemäß einem der vorherigen Ansprüche, wobei die zumindest eine Kavität (13, 14, 14a, 14b) mit Luft, einem Gas oder einem Vakuum gefüllt ist.

11. Antennenmodul gemäß einem der vorherigen Ansprüche, wobei das zweite Substrat einen Wafer (10) aufweist, der die Kavität (14a, 14b) verschließt..

12. Antennenmodul gemäß einem der vorherigen Ansprüche, wobei das Antennenmodul ein thermisches Element (11) aufweist, insbesondere ein thermisches Element (11) in der zumindest einen Kavität (13, 14, 14a, 14b), ein thermisches Element (11), das auf einem Boden der zumindest einen Kavität (13, 14, 14a, 14b), oder ein thermisches Element (11), das dem RF-Chip (4) zugeordnet ist, aufweist.

13. Antennenmodul gemäß einem der vorherigen Ansprüche, wobei das zweite Substrat (5, 5', 5") als Schichtstapel mit zumindest zwei Einzelsubstraten ausgeführt ist; oder wobei das zweite Substrat (5, 5', 5") als Schichtstapel mit zumindest zwei Einzelsubstraten ausgeführt ist; wobei ein erstes der mindesten zwei Einzelsubstrate eine oder mehrere Kavitäten und/oder eine oder mehrere sich durch das erste der mindesten zwei Einzelsubstrate erstreckende Öffnungen aufweist und das zweite der mindestens zwei Einzelsubstrate zur Verkapselung der einen oder mehreren Öffnungen dient, um die eine oder mehreren Kavitäten zu formen.

14. Herstellungsverfahren für ein Antennenmodul mit folgenden Schritten:
Bereitstellen eines ersten Substrats (1);
Bereitstellen eines zweiten Substrats (5, 5', 5"), wobei das zweite Substrat (5, 5', 5") zumindest eine Kavität (13, 14, 14a, 14b) an einer ersten Hauptoberfläche aufweist,
wobei das erste Substrat (1) mit seiner ersten Hauptoberfläche mit der ersten Hauptoberfläche des zweiten Substrats (5, 5', 5") verbunden ist;
wobei das erste Substrat (1) zumindest ein RF-Antennenelement (3) aufweist, insbesondere einen RF-Chip (4) und/oder eine RF-Leiterbahn aufweist, wobei das Antennenelement oder der RF-Chip (4) oder die RF-Leiterbahn auf einer ersten Hauptoberfläche des ersten Substrats (1) angeordnet ist; und
Verbinden des ersten Substrats mit seiner ersten Hauptoberfläche mit der ersten Hauptoberfläche des zweiten Substrats (5, 5', 5"), so dass das RF-Antennenelement (3) oder der RF-Chip (4) oder die RF-Leiterbahn (7) aus der ersten Hauptoberfläche des ersten Substrats hinausragt und in die zumindest eine Kavität (13, 14, 14a, 14b) hineinragt,
wobei das erste Substrat (1) ein hochohmiges oder isolierendes Substrat ist, insbesondere ein Glasmaterial, oder ein Keramikmaterial oder ein Polymermaterial aufweist, dadurch gekenzeichnet, dass die zumindest eine Kavität (13) eine elektrisch kontaktierte Kavitätenmetallisierung (7) mit einer reduzierten Breite aufweist, sodass sich die Kavitätenmetallisierung (7) nur über einen Bereich der zumindest einen Kavität (13) erstreckt;
wobei das Antennenmodul ein Metamaterial (8), das auf einem Boden der zumindest einen Kavität (13, 14, 14a, 14b) angeordnet ist und das dem RF-Antennenelement (3) zugeordnet ist, aufweist.

15. Herstellungsverfahren gemäß Anspruch 14, wobei der Schritt des Verbindens mittels Flip-Chip-Technologie oder Face-to-Face Waferbonding ausgeführt ist.

16. Herstellungsverfahren gemäß Anspruch 14 oder 15, wobei vor dem Bereitstellen des zweiten Substrats (5, 5', 5") der Schritt des Strukturierens, Ätzens, Trockenätzens zum Einbringen der zumindest einen Kavität (13, 14, 14a, 14b) in die erste Hauptoberfläche erfolgt; und/oder
wobei vor dem Bereitstellen des ersten Substrats und/oder des zweiten Substrats (5, 5', 5") ein Schritt der Halbleiterherstellung erfolgt, um ein RF-Element, eine Leiterbahn, ein Metamaterial (8), ein thermisches Element (11), eine RF-Leiterbahn, einen RF-Chip (4) und/oder ein RF-Antennenelement (3) auf das erste (1)/oder zweite Substrat (5, 5', 5") zu formen.

17. Herstellungsverfahren gemäß Anspruch 14, 15 oder 16, wobei das Verfahren den Schritt des Dünnens des ersten Substrats (1) und/oder des zweiten Substrats (5, 5', 5") nach dem Verbinden aufweist.

## Claims

1. Antenna module, comprising:
a first substrate (1),
a second substrate (5, 5', 5"), said second substrate (5, 5', 5") comprising at least one cavity (13, 14, 14a, 14b) at a first main surface,
wherein the first substrate (1) comprises at least an RF antenna element (3), in particular an RF chip (4) and/or an RF conductive trace, the RF antenna element (3) or the RF chip (4) or the RF conductive trace being arranged on or in a first main surface of the first substrate (1),
wherein the first substrate (1) is connected, with its first main surface, to the first main surface of the second substrate (5, 5', 5"),
wherein the RF antenna element (3) or the RF chip (4) or the RF conductive trace projects out of the first main surface and into the at least one cavity (13, 14, 14a, 14b),
wherein the first substrate (1) is a high-resistance or an insulating substrate, in particular comprising a glass material or a ceramic material or a polymer material,
**characterized in that** the at least one cavity (13) comprises an electrically contacted cavity metallization (7) having a reduced width so that the cavity metallization (7) extends only across an area of the at least one cavity (13),
wherein the antenna module comprises a meta material (8) being arranged on a bottom of the at least one cavity (13, 14, 14a, 14b) and associated with the RF antenna element (3).

2. Antenna module as claimed in claim 1, wherein several cavities (13, 14, 14a, 14b) are provided at the first main surface of the second substrate (5, 5', 5"), which are associated with different RF elements.

3. Antenna module as claimed in any one of the preceding claims, wherein the second substrate (5, 5', 5") is formed by a substrate stack, or
wherein the second substrate (5, 5', 5") is formed by a substrate stack and the substrate stack comprises a substrate (1) or a substrate (1) which acts as a lid element for the cavity (13, 14, 14a, 14b).

4. Antenna module as claimed in any one of the preceding claims, wherein the second substrate (5, 5', 5") comprises a conductive trace, in particular a conductive trace on the first main surface, a conductive trace in the at least one cavity (13, 14, 14a, 14b) or a conductive trace on a bottom of the at least one cavity (13, 14, 14a, 14b).

5. Antenna module as claimed in any one of the preceding claims, wherein the connection between the first substrate (1) and the second substrate (5, 5', 5") is formed by an adhesive layer, an insulating adhesive layer or an insulating layer.

6. Antenna module as claimed in any one of the preceding claims, wherein the second substrate (5, 5', 5") comprises one or more vias (9), in particular one or more vias (9) which project through the second substrate (5, 5', 5").

7. Antenna module as claimed in any one of the preceding claims, wherein the second substrate (5, 5', 5") comprises a semiconductor material.

8. Antenna module as claimed in any one of the preceding claims, wherein the cavity metallization (7) extends across a partial area of the cavity (13) or wherein the cavity metallization (7) is patterned.

9. Antenna module as claimed in any one of the preceding claims, wherein the first substrate (1) and/or the second substrate (5, 5', 5") is formed by a thinned substrate.

10. Antenna module as claimed in any one of the preceding claims, wherein the at least one cavity (13, 14, 14a, 14b) is filled with air, a gas or a vacuum.

11. Antenna module as claimed in any one of the preceding claims, wherein the second substrate comprises a wafer (10) closing the cavity (14a, 14b).

12. Antenna module as claimed in any one of the preceding claims, wherein the antenna module comprises a thermal element (11), in particular a thermal element (11) in the at least one cavity (13, 14, 14a, 14b), a thermal element (11) arranged on a bottom of the at least one cavity (13, 14, 14a, 14b), or a thermal element (11) associated with the RF chip (4).

13. Antenna module as claimed in any one of the preceding claims, wherein the second substrate (5, 5', 5") is configured as a layer stack comprising at least two individual substrates; or wherein the second substrate (5, 5', 5") is configured as a layer stack comprising at least two individual substrates, wherein a first one of said at least two individual substrates comprises one or more cavities and/or one or more openings extending through the first one of the at least two individual substrates, and the second one of the at least two individual substrates serves to encapsulate said one or more openings so as to form the one or more cavities.

14. Method of manufacturing an antenna module, comprising:
providing a first substrate (1);
providing a second substrate (5, 5', 5"), said second substrate (5, 5', 5") comprising at least one cavity (13, 14, 14a, 14b) at a first main surface,
wherein the first substrate (1) is connected, with its first main surface, to the first main surface of the second substrate (5, 5', 5"),
wherein the first substrate (1) comprises at least an RF antenna element (3), in particular an RF chip (4) and/or an RF conductive trace, the antenna element or the RF chip (4) or the RF conductive trace being arranged on a first main surface of the first substrate (1); and
connecting the first substrate, with its first main surface, to the first main surface of the second substrate (5, 5', 5") so that the RF antenna element (3) or the RF chip (4) or the RF conductive trace (7) projects out of the first main surface and into the at least one cavity (13, 14, 14a, 14b),
wherein the first substrate (1) is a high-resistance substrate or an insulating substrate, in particular comprising a glass material, a ceramic material or a polymer material,
**characterized in that** the at least one cavity (13) comprises an electrically contacted cavity metallization (7) with a reduced width so that the cavity metallization (7) extends only across an area of the at least one cavity (13),
wherein the antenna module (8) comprises a meta material (8) being arranged on a bottom of the at least one cavity (13, 14, 14a, 14b) and associated with the RF antenna element (3).

15. Method of manufacturing as claimed in claim 14, wherein connecting is implemented by means of flip-chip technology or face-to-face wafer bonding.

16. Method of manufacturing as claimed in claim 14 or 15, wherein providing the second substrate (5, 5', 5") is preceded by patterning, etching, dry etching for incorporating the at least one cavity (13, 14, 14a, 14b) into the first main surface; or
wherein providing of the first substrate and/or of the second substrate (5, 5', 5") is preceded by semiconductor manufacturing so as to form an RF element, a conductive trace, a meta material (8), a thermal element (11), an RF conductive trace, an RF chip (4) and/or an RF antenna element (3) onto the first (1) or second substrate (5, 5', 5").

17. Method of manufacturing as claimed in claim 14, 15 or 16, wherein the method comprises thinning the first substrate (1) and/or the second substrate (5, 5', 5") following connection.

## Revendications

1. Module d'antenne, comprenant les caractéristiques suivantes :
un premier substrat (1),
un second substrat (5, 5', 5"), dans lequel le second substrat (5, 5', 5") présente au moins une cavité (13, 14, 14a, 14b) sur une première surface principale,
dans lequel le premier substrat (1) présente au moins un élément d'antenne RF (3), en particulier une puce RF (4) et/ou une piste conductrice RF, l'élément d'antenne RF (3) ou la puce RF (4) ou la piste conductrice RF étant disposé(e) sur ou dans une première surface principale du premier substrat (1),
dans lequel le premier substrat (1) est connecté avec sa première surface principale à la première surface principale du second substrat (5, 5', 5") ;
dans lequel l'élément d'antenne RF (3) ou la puce RF (4) ou la piste conductrice RF fait saillie de la première surface principale du premier substrat et avance dans l'au moins une cavité (13, 14, 14a, 14b),
dans lequel le premier substrat (1) est un substrat à haute impédance ou isolant, en particulier présente un matériau en verre ou un matériau en céramique ou un matériau polymère,
**caractérisé en ce que** l'au moins une cavité (13) présente une métallisation de cavité (7) mise en contact électriquement avec une largeur réduite de telle sorte que la métallisation de cavité (7) ne s'étende que sur une région de l'au moins une cavité (13) ;
dans lequel le module d'antenne présente un métamatériau (8) qui est disposé sur un fond de l'au moins une cavité (13, 14, 14a, 14b) et qui est associé à l'élément d'antenne RF (3).

2. Module d'antenne selon la revendication 1, dans lequel plusieurs cavités (13, 14, 14a, 14b) sont prévues pour la première surface principale du second substrat (5, 5', 5") et sont associées à différents éléments RF.

3. Module d'antenne selon une des revendications précédentes, dans lequel le second substrat (5, 5', 5") est formé par un empilement de substrats, ou
dans lequel le second substrat (5, 5', 5") est formé par un empilement de substrats et l'empilement de substrats comprend un substrat (1) ou un substrat (1) qui sert d'élément de recouvrement pour l'au moins une cavité (13, 14, 14a, 14b).

4. Module d'antenne selon une des revendications précédentes, dans lequel le second substrat (5, 5', 5") présente une piste conductrice, en particulier une piste conductrice sur la première surface principale, une piste conductrice dans l'au moins une cavité (13, 14, 14a, 14b) ou une piste conductrice sur un fond de l'au moins une cavité (13, 14, 14a, 14b).

5. Module d'antenne selon une des revendications précédentes, dans lequel la connexion entre le premier substrat (1) et le second substrat (5, 5', 5") est formée par une couche adhésive, une couche adhésive isolante ou une couche isolante.

6. Module d'antenne selon une des revendications précédentes, dans lequel le second substrat (5, 5', 5") présente un ou plusieurs trous de liaison (9), en particulier un ou plusieurs trous de liaison (9) qui font saillie à travers le second substrat (5, 5', 5").

7. Module d'antenne selon une des revendications précédentes, dans lequel le second substrat (5, 5', 5") présente un matériau semiconducteur.

8. Module d'antenne selon une des revendications précédentes, dans lequel la métallisation de cavité (7) s'étend sur une région partielle de la cavité (13) ou dans lequel la métallisation de cavité (7) est structurée.

9. Module d'antenne selon une des revendications précédentes, dans lequel le premier substrat (1) et/ou le second substrat (5, 5', 5") est formé par un substrat aminci.

10. Module d'antenne selon une des revendications précédentes, dans lequel l'au moins une cavité (13, 14, 14a, 14b) est remplie d'air, de gaz ou de vide.

11. Module d'antenne selon une des revendications précédentes, dans lequel le second substrat présente une tranche (10) qui obture la cavité (14a, 14b).

12. Module d'antenne selon une des revendications précédentes, dans lequel le module d'antenne présente un élément thermique (11), en particulier présente un élément thermique (11) dans l'au moins une cavité (13, 14, 14a, 14b), un élément thermique (11) sur un fond de l'au moins une cavité (13, 14, 14a, 14b) ou un élément thermique (11) qui est associé à la puce RF (4).

13. Module d'antenne selon une des revendications précédentes, dans lequel le second substrat (5, 5', 5") est réalisé sous la forme d'un empilement de couches avec au moins deux substrats individuels ; ou dans lequel le second substrat (5, 5', 5") est réalisé sous la forme d'un empilement de couches avec au moins deux substrats individuels ; dans lequel un premier des au moins deux substrats individuels présente une ou plusieurs cavités et/ou une ou plusieurs ouvertures qui s'étendent à travers le premier des au moins deux substrats individuels et le second des au moins deux substrats individuels sert à encapsuler l'une ou plusieurs ouvertures pour former l'une ou plusieurs cavités.

14. Procédé de fabrication d'un module d'antenne avec les étapes suivantes :
fournir un premier substrat (1) ;
fournir un second substrat (5, 5', 5"), dans lequel le second substrat (5, 5', 5") présente au moins une cavité (13, 14, 14a, 14b) sur une première surface principale,
dans lequel le premier substrat (1) est connecté avec sa première surface principale à la première surface principale du second substrat (5, 5', 5") ;
dans lequel le premier substrat (1) présente au moins un élément d'antenne RF (3), en particulier présente une puce RF (4) et/ou une piste conductrice RF, l'élément d'antenne ou la puce RF (4) ou la piste conductrice RF étant disposé(e) sur une première surface principale du premier substrat (1) ; et
connecter le premier substrat avec sa première surface principale à la première surface principale du second substrat (5, 5', 5") de telle sorte que l'élément d'antenne RF (3) ou la puce RF (4) ou la piste conductrice RF (7) fasse saillie de la première surface principale du premier substrat et avance dans l'au moins une cavité (13, 14, 14a, 14b),
dans lequel le premier substrat (1) est un substrat à haute impédance ou isolant, en particulier présente un matériau en verre ou un matériau en céramique ou un matériau polymère,
**caractérisé en ce que** l'au moins une cavité (13) présente une métallisation de cavité (7) mise en contact électriquement avec une largeur réduite de telle sorte que la métallisation de cavité (7) ne s'étende que sur une région de l'au moins une cavité (13) ;
dans lequel le module d'antenne présente un métamatériau (8) qui est disposé sur un fond de l'au moins une cavité (13, 14, 14a, 14b) et qui est associé à l'élément d'antenne RF (3).

15. Procédé de production selon la revendication 14, dans lequel l'étape de connexion est réalisée à l'aide d'une technologie de puce retournée ou d'une connexion de tranche face-à-face.

16. Procédé de production selon la revendication 14 ou 15, dans lequel, avant de fournir le second substrat (5, 5', 5"), est effectuée une étape de structuration, de gravure, de gravure sèche pour introduire l'au moins une cavité (13, 14, 14a, 14b) dans la première surface principale ; et/ou
dans lequel, avant de fournir le premier substrat et/ou le second substrat (5, 5', 5"), une étape de fabrication de semiconducteur est effectuée pour former un élément RF, une piste conductrice, un métamatériau (8), un élément thermique (11), une piste conductrice RF, une puce RF (4) et/ou un élément d'antenne RF (3) sur le premier (1) ou le second substrat (5, 5', 5").

17. Procédé de production selon la revendication 14, 15 ou 16, dans lequel le procédé présente l'étape destinée à amincir le le premier substrat (1) et/ou le second substrat (5, 5', 5") après la connexion.
